(19) Europäisches Patentamt
European Patent Office
Office européen des brevets

(11) **EP 3 440 813 B1**

(12) **EUROPEAN PATENT SPECIFICATION**

(45) Date of publication and mention
of the grant of the patent:
**13.01.2021 Bulletin 2021/02**

(51) Int Cl.:
*H04L 7/00* (2006.01)      *H04L 25/06* (2006.01)
*H04L 7/033* (2006.01)

(21) Application number: **16718325.0**

(86) International application number:
**PCT/EP2016/058916**

(22) Date of filing: **21.04.2016**

(87) International publication number:
**WO 2017/182082 (26.10.2017 Gazette 2017/43)**

(54) **APPARATUS AND METHOD FOR RECOVERING CLOCK DATA FROM AN M-LEVEL SIGNAL**

VORRICHTUNG UND VERFAHREN ZUR RÜCKGEWINNUNG VON TAKTDATEN AUS EINEM M-PEGEL-SIGNAL

APPAREIL ET PROCÉDÉ POUR RÉCUPÉRER DES DONNÉES D'HORLOGE À PARTIR D'UN SIGNAL DE NIVEAU M

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**13.02.2019 Bulletin 2019/07**

(73) Proprietor: **Huawei Technologies Co., Ltd.**
**Longgang District**
**Shenzhen, Guangdong 518129 (CN)**

(72) Inventors:
• **STOJANOVIC, Nebojsa**
  **80992 Munich (DE)**
• **PRODANIUC, Cristian**
  **80992 Munich (DE)**
• **KARINOU, Fotini**
  **80992 Munich (DE)**

(74) Representative: **Körber, Martin Hans**
**Mitscherlich PartmbB**
**Patent- und Rechtsanwälte**
**Sonnenstrasse 33**
**80331 München (DE)**

(56) References cited:
**EP-A1- 2 945 335      US-A1- 2004 141 567**
**US-B1- 9 184 906**

• **F.A. MUSA ET AL: "Clock recovery in high-speed multilevel serial links", PROCEEDINGS OF THE 2003 INTERNATIONAL SYMPOSIUM ON CIRCUITS AND SYSTEMS, 2003. ISCAS 2003, vol. 5, 1 January 2003 (2003-01-01), pages V-449, XP055326995, DOI: 10.1109/ISCAS.2003.1206313 ISBN: 978-0-7803-7761-5**

**Description**

TECHNICAL FIELD

The present invention relates to an apparatus and method for recovering clock and data from an M-level signal of a receiver in a transmission system, such as - but not limited to - a fiber optical transmission system with direct detection optical receivers.

BACKGROUND

In optical communications, intensity modulation (IM) is a form of modulation in which the optical power output of a source is varied in accordance with some characteristic of the modulation signal. The envelope of the modulated optical signal corresponds to the modulating signal in the sense that the instantaneous power of the envelope is an envelope of the characteristic of interest in the modulation signal. Recovery of the modulating signal is usually achieved by direct detection (DD).

Next-generation ultra high-speed short-range optical fiber links will utilize small, cheap, and low power consumption transceivers. All these requirements are mainly imposed due to the limited space of data center equipment. The transceivers should support intra- and inter-data center connections from a few hundred meters up to several tens of kilometers, respectively.

Data centers are facilities that store and distribute the data on the Internet. With an estimated 100 billion plus web pages on over 100 million websites, data centers contain a lot of data. With almost two billion users accessing all these websites, including a growing amount of high bandwidth video, it's easy to understand but hard to comprehend how much data is being uploaded and downloaded every second on the Internet. A data center, as defined in the ANSI/TIA/EIA-942 standard "Telecommunications Infrastructure Standard for Data Centers", is a building or portion of a building whose primary function is to house a computer room and its support areas. The main functions of a data center are to centralize and consolidate information technology (IT) resources, house network operations, facilitate e-business and to provide uninterrupted service to mission-critical data processing operations. Data centers can be part of an enterprise network, a commercial venture that offers to host services for others or a co-location facility where users can place their own equipment and connect to the service providers over the building's connections. Data centers may serve local area networks (LANs) or wide area networks (WAN) and may be comprised of switches connecting user devices to server devices and other switches connecting server devices to storage devices.

A preferred solution may be to transmit 100 Gbit/s per wavelength, which is very challenging when a very cheap solution is required. A coherent approach is out of scope as it requires high power and expensive devices. Therefore, IM and DD schemes are preferred. The mature on-off keying modulation format, widely used in non-coherent systems has been also investigated for so-called 100-G applications at 100 Gbit/s per wavelength speed. However, such a solution would require expensive high-bandwidth optics and electronics. To overcome this drawback, advanced modulation formats supported by digital signal processing (DSP) have been investigated as an alternative technology to support 100-G applications, the most promising candidates being duobinary 4-level pulse amplitude modulation (DB-PAM-4), discrete multi-tone modulation (DMT), and carrier-less amplitude and phase modulation (CAP). All the aforementioned approaches require either expensive components or enhanced DSP or both of them and cannot be considered as serious candidates for data center connections.

As a DSP has to be avoided, simple analog equalization schemes included in a clock data recovery block are needed. DMT and CAP require transmitter and receiver DSP blocks and are not considered seriously for cheap transceivers. Then, the PAM-4 format is remaining as one option, since a transmitter (Tx) does not require a digital-to-analog converter (DAC). Also, at the receiver side, a high resolution analog-to-digital converter (ADC) is not necessary if the transmission systems can be designed to provide an acceptable bit error rate (BER) for a forward error correction (FEC) block.

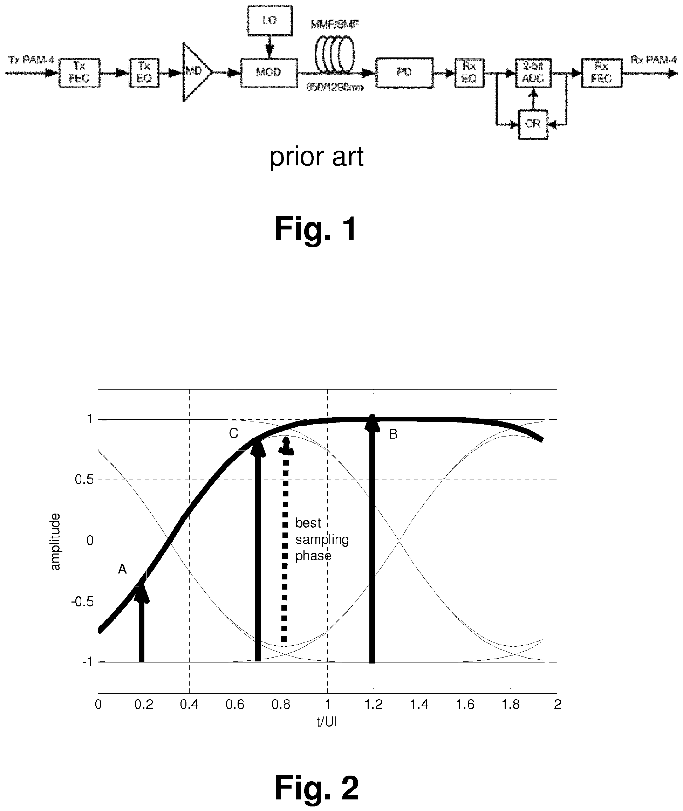

Fig. 1 shows a schematic block diagram of a conventional IM/DD transmission system. A transmission PAM-4 signal (Tx PAM-4) is FEC encoded by an encoder (Tx FEC) and equalized by an equalizer (Tx EQ) at the transmitter side, e.g. by using a simple analog equalizer (pre-emphases), amplified by a modulator driver (MD) and converted in the optical domain by a modulator (MOD) and a local oscillator laser (LO). The obtained optical signal is transmitted over multimode fiber (MMF) or single mode fiber (SMF) and detected by using a photo diode (PD). The obtained electrical signal is equalized (Rx EQ) e.g. by a continuous-time linear equalizer or a few taps finite impulse response filter (FIR). A subsequent clock recovery (CR) uses signals before and after 2-bit ADC to extract clock from the received signal. After FEC decoder (Rx FEC) the BER of an obtained PAM-4 signal (Rx PAM-4) at the receiver output should be below some predefined threshold.

The architecture of Fig. 1 is a simple and cheap solution for an optical transmission system. All blocks can operate at high speed and clock recovery block can be kept simple. However, due to bandwidth limitations of electrical circuits, it is not a preferred solution to work with analog values and at frequencies higher than symbol rate. So far, in PAM-4 systems for example, CR based on two samples per symbols is implemented. In on-off keying (OOK) systems a preferable CR was based on an Alexander nonlinear phase detector that uses two samples per symbol and a specific logic to derive clock, as described in J. D. H. Alexander, Electron. Lett. vol. 11, pp. 541 - 542, (1975). This phase detector uses three samples A, B and C at 2fs frequency, where fs corresponds to the symbol rate, with fs=1/UI where UI corresponds to a unit interval (i.e. the time period T) and makes a decision whether the clock is early or late. Phase detector outputs can be expressed as "-", "0", and "+" (which can mean "early", "ambiguous", and "late", respectively). The signs of samples can be expressed as "-" and "+", while "+/-" means that this sample is irrelevant if other conditions are fulfilled.

R. Farjad-Rad, et al., IEEE Journal of Solid State Circuits. vol. 35, 757-764 (2000) and J.L. Zerbe et al., IEEE Journal of Solid State Circuits. vol. 38, 2121-2130 (2003) disclose linear and, respectively, nonlinear phase detectors using two samples per symbol, which are often used in practical PAM-4 systems. The linear variant deals with analog and digital signals, selects "good transitions", and has very good jitter performance but the main problem comes from oversampling and handling analog values. The nonlinear variant is based on selective transitions of an Alexander phase detector. This variant introduces more jitter but the implementation is not difficult at medium symbol rates. A disadvantage of these two variants is oversampling that presents a big problem at high data speeds, e.g. 56G where 112G clock is required. Some solutions based on single sample per symbol suffer either from the fact that they require analog signal processing or there are problems related to timing error detector characteristic (TEDC) such as asymmetric shape or large hang-up range.

Document "Clock recovery in high-speed multilevel serial links" by Faisal . Musa et al. 2013 discloses a clock recovery method using a minimum mean squared error algorithm.

Document EP 2945335 A1 discloses a partial response receiver comprising a 4-PAM partial response receiver.

It should be noted that in general, for well-designed phase detectors, two samples per symbol are always better than one sample per symbol. In the ideal case (i.e., no implementation constraints), analog phase detectors are also better than digital (quantized) phase detectors.

An eye diagram is a common indicator of the quality of signals in high-speed digital transmissions. An oscilloscope generates an eye diagram by overlaying sweeps of different segments of a long data stream driven by a master clock. Overlaying many bits produces an eye diagram, so called because the resulting image looks like the opening of an eye. In an ideal world, eye diagrams would look like rectangular boxes. In reality, communications are imperfect, so the transitions do not line perfectly on top of each other, and an eye-shaped pattern results. Differences in timing and amplitude from bit to bit cause the eye opening to shrink.

Fig. 2 present an example of an early sampling phase with samples A, B, and C and a best sampling phase (BSP) at the highest opening of an eye diagram, where sample C is shortly before the best sampling phase. The Alexander phase detector uses only the signs of three samples and drives an oscillator.

A truth table is a mathematical table used in logic - specifically in connection with Boolean algebra, Boolean functions, and propositional calculus - to compute the functional values of logical expressions on each of their functional arguments, that is, on each combination of values taken by their logical variables. Practically, a truth table is composed of one column for each input variable, and one final column for all of the possible results of the logical operation that the table is meant to represent. Each row of the truth table therefore contains one possible configuration of the input variables and the result of the operation for those values.

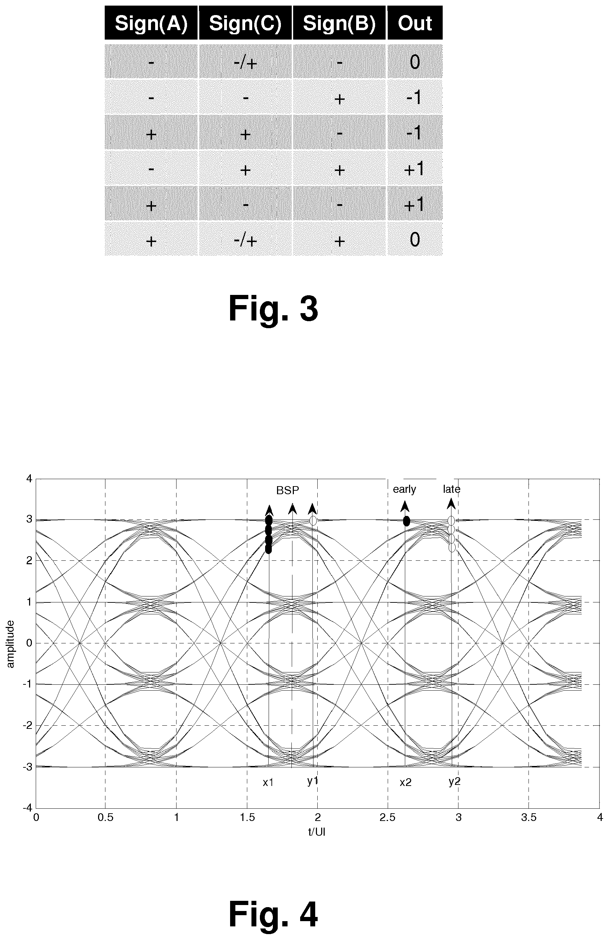

Fig. 3 shows a truth table of an Alexander phase detector, where the respective signs Sign(A), Sign(B) and Sign(C) of the samples A, B and C of Fig. 2 with respect to the best sampling phase are used as input variables of the truth table to derive output values -1, 0, and +1 for controlling the oscillator. The values "-", "0" and "+" can be interpreted in the sense of "early", "ambiguous" and "late", respectively. However, as already mentioned above, this phase detector is disadvantageous due to oversampling and high jitter in PAM-4 systems.

SUMMARY

It is an object of the present invention to provide a clock recovery apparatus according to independent claim 1 and method according to independent claim 9, by means of which clock recovery can be further simplified and sampling speed can be lowered.

The foregoing and other objects are achieved by the features of the independent claims. Further implementation forms are apparent from the dependent claims, the description and figures.

According to a first aspect there is provided an apparatus for recovering clock and data from an M-level signal of a receiver in a transmission system, the apparatus having an input, a data output and a clock output and comprising an M-level $\log_2(M)$-bit analog-to-digital converter connected at the input of the apparatus, the M-level $\log_2(M)$-bit analog-to-digital converter being adapted to convert a first analog data (x1) of the M-level signal to a digital data received at the data output; a first comparator connected at the input of the apparatus, the first comparator being adapted to compare an amplitude difference between the first analog data (x1) and a second analog data(x2); and a logic unit connected at the clock output of the apparatus, the logic unit being adapted to provide through a truth table a digital output signal based on the digital data and the result of comparison of the amplitude difference, wherein the first analog data (x1) and the second analog data (x2) are sampled at a distance of one symbol period with respect to each of the first analog data (x1) and the second analog data (x2); and the first analog data (x1) and the second analog data (x2) have an identical polarity.

The above object is also solved in accordance with a second aspect.

According to the second aspect, there is provided a method for recovering clock and data from an M-level signal of a receiver in a transmission system, the method comprising the following steps: converting a first analog data (x1) of the M-level signal to a digital data; comparing an amplitude difference between the first analog data (x1) and a second analog data (x2); and providing through a truth table a digital output signal based on the digital data and the result of comparison of the amplitude difference, wherein: the first analog data (x1) and the second analog data (x2) are sampled at a distance of one symbol period with respect to each of the first analog data (x1) and the second analog data (x2); and the first analog data (x1) and the second analog data (x2) have an identical polarity.

Accordingly, the proposed clock recovery or derivation approach can be advantageously used in transmission systems with M-level signals (e.g. PAM-4 or PAM-8 or other multi-level transmission systems), since the new phase detector uses one sample per symbol that enables clock extraction at very high Baud rates, since it is easy to implement as it requires only digital circuits and does not deal with analog values, and since the novel phase detection approach can enable timing in high-speed systems where the multi-level (e.g. PAM-4 or PAM-8) signal is available before clock and data recovery (CDR). The new approach can be achieved by using high bandwidth components and systems that do not require an enhanced DSP after the ADC block, which an important target for small-size and low-power consumption transceivers.

It is noted that the above apparatus may be implemented based on discrete hardware circuitry with discrete hardware components, integrated chips, or arrangements of chip modules, or based on a signal processing device or chip controlled by a software routine or program stored in a memory, written on a computer-readable medium, or downloaded from a network, such as the internet. The above apparatuses may be implemented without signal transmission or receiving capability simply for controlling the transmission or reception function of a corresponding transmitter device or receiver device.

According to a first implementation of the apparatus according to the first aspect, the M-level log2(M)-bit analog-to-digital converter may comprise M-1 comparators and M-1 D-type flip-flops, each one of the M-1 D-type flip-flops being connected to a respective output of each one of the M-1 comparators. This first implementation provides a simple solution based on comparators and flip-flop devices.

According to a second implementation of the apparatus according to the first implementation of the first aspect, the M-1 comparators and the first comparator provide an output of logic value being either -1 or +1.

According to a third implementation of the apparatus according to the first or second implementation of the first aspect, the digital output signal may be given through the truth table by the following equation: (sign(x1)+sign(x2))*sign(x1-x2), where |x1| > M-2, |x2| > M-2, sign(x1) and sign(x2) correspond to the polarity of the logic value output by a second comparator amongst the M-1 comparators, the second comparator outputting the most significant bit (MSB), and sign(x1-x2) corresponds to the polarity of the logic value output by the first comparator. Hence, the second implementation offers a simple straight-forward option how to use the comparators and flip-flops to derive the digital output signal.

According to a fourth implementation of the apparatus according to any preceding implementation of the first aspect or the first aspect as such, the M-level signal may be an M-pulse amplitude modulation signal. The use of PAM-m signals provides the advantage that no DAC is required at the transmitter side.

According to a fifth implementation of the apparatus according to any preceding implementation of the first aspect or the first aspect as such, the first analog data (x2) and the second analog data (x1) may have an amplitude outside the range from 2-M to M-2. Due to the fact that only amplitudes beyond the minimum limits 2-M and M-2 are considered, reliability of clock recovery can be increased.

According to sixth implementation of the apparatus according to the first implementation of the first aspect, M may equal 4 and the M-1 comparators may have respective reference amplitude thresholds equal to -2, 0 and +2 and the M-level analog signal may have amplitude levels equal to -3, -1, +1 and +3. Such a PAM-4 implementation provides a good compromise between reliable clock recovery and complexity concerning the number of circuit components.

According to a seventh implementation of the apparatus according to the first implementation of the first aspect, M may equal 8 and the M-1 comparators may have respective reference amplitude thresholds equal to -6, 0 and +6 and the M-level analog signal may have amplitude levels equal to -7, -5, -3, -1, +1, +3, +5 and +7. Such a PAM-8 implementation provides more level comparisons and thus better resolution and control options.

According to an eighth implementation of the apparatus according to the sixth or seventh implementation of the first aspect, at least the output of the highest comparator may be inverted. Thereby, Gray code mapping of the PAM signal can be achieved, so that it can be efficiently used for Gray coding and phase detection logic.

According to an ninth implementation of the apparatus according to any preceding implementation of the first aspect or the first aspect as such, the apparatus may further comprise: a filter adapted to filter the digital output signal; and an oscillator adapted to receive the filtered digital output signal and generate a clock signal based on the received filtered digital output signal. Thereby, a simple approach can be provided for generating the desired clock signal from the digital output signal.

According to a first implementation of the method according to the second aspect, the method may further comprise the following steps: filtering the digital output signal; receiving the filtered digital output signal; and generating a clock signal based on the received filtered digital output signal. Similar to the above eighth implementation, a simple approach can be provided for generating the desired clock signal from the digital output signal.

Embodiments of the invention can be implemented in hardware, software or any combination thereof.

It shall further be understood that a preferred embodiment of the invention can also be any combination of the dependent claims or above embodiments with the respective independent claim.

These and other aspects of the invention will be apparent and elucidated with reference to the embodiments described hereinafter.

BRIEF DESCRIPTION OF THE DRAWINGS

In the following detailed portion of the present disclosure, the invention will be explained in more detail with reference to exemplary embodiments shown in the drawings, in which:

Fig. 1     shows a schematic block diagram of a simple conventional PAM-4 transmission system in which the present invention can be implemented;

Fig. 2     shows a time diagram with a schematic eye diagram of a received signal with different sampling phases in case of an early sampling;

Fig. 3     shows a truth table of a conventional Alexander phase detector;

Fig. 4     shows a time diagram with a schematic eye diagram of a received multi-level signal and different sampling points according to an embodiment of the present invention;

Fig. 5     shows a truth table of a phase detector according to an embodiment of the present invention;

Fig. 6     shows a functional block diagram of a receiver with digital filter and clock and data recovery used in connection with an embodiment of the present invention;

Fig. 7     shows time diagrams with eye diagrams before and after equalization;

Fig. 8     shows a schematic diagram which indicates characteristics of bit error rates over input power for a conventional linear phase detector and a phase detector according an embodiment; and

Fig. 9     shows a schematic block diagram of a clock and data recovery device using a phase detector according an embodiment.

Identical reference signs are used for identical or at least functionally equivalent features.

DETAILED DESCRIPTION

According to the following embodiments, a new phase detection approach for use in connection with clock and/or data derivation or recovery in multi-level signal transmission systems (e.g. PAM-4, PAM-8 or other numbers of levels) is provided. The new phase detection approach uses only one sample per symbol that enables the clock extraction at very high Baud rates and can be implemented based on pure digital architecture with lowest sampling speed to recover the transmitted multi-level signal. Circuit schemes are thus easy to implement as they requires only digital circuits and do not have to cope with analog values. The proposed phase detection approach can enable timing in high-speed systems where the multi-level signal is already available before clock and data recovery. It can be achieved by using high bandwidth components and systems that do not require an enhanced DSP after the ADC block. It is thus very suitable for small-size and low-power consumption transceivers. Various embodiments of the present invention will now be described based on a PAM-4 transmission system for an optical fiber. The new algorithm of the proposed new phase detection approach works with single sample per symbol. The PAM-4 signal levels are equal to -3, -1, +1, and +3.

Fig. 4 shows a time diagram of signal amplitude versus normalized time (t/UI) with a schematic 4-level eye diagram of the received PAM-4 signal and different sampling points x1, y1, x2, and y2 according to an embodiment of the present invention. The best sampling position is indicated by the dashed arrow "BSP". At this position, the eye diagrams have their maximum opening, so that the best signal-to-noise ration can be obtained.

The first rule of the proposed phase detection scheme is to discard all samples that are in the range from amplitude level "-2" to amplitude level "2" in Fig. 4. This is a so-called bad region. Two consecutive samples x1 and x2 (or y1 and y2) that are out of this range are considered. The second rule is that both samples should have the same most significant bit, i.e. both samples should be positive or negative. These two samples are then compared and the sign of this operation is used for phase detection output derivation.

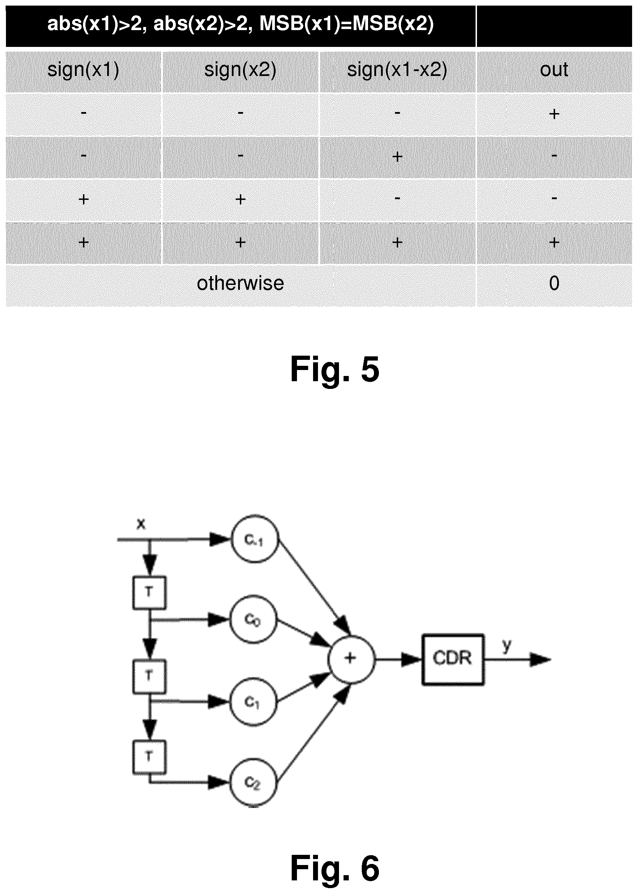

Fig. 5 shows a truth table of a phase detector according to an embodiment of the present invention. The phase detector output "out" output may be later filtered and used to drive a clock oscillator. As can be gathered from this truth table, only those cases where samples x1 and x2 have identical signs are considered. The sign of the difference x1-x2 is shown in the third column. In the first and fourth row, the absolute value of x1 is larger than the absolute value of x2. To the contrary, in the second and third row, the absolute value of x2 is larger than the absolute value of x1. In case of a positive output ("+"), the absolute value of x1 is larger than the absolute value of x2. The smallest value of the difference (i.e., x1-x2=0) indicates the stable (equilibrium) sampling point.

The main cause of negative phase detector outputs is indicated by black symbols (black circles) in Fig. 4 in case of positive samples (x1 and x2). There are four acceptable transitions of type x-3-3-x and three of them will produce a negative phase detector value while only one (3-3-3) gives a zero output. The opposite case is with samples y1 and y2 (empty cycles). In this case, three acceptable transitions produce positive value while one of them is neutral.

A 28GB PAM-4 system (as shown in Fig. 1) with an externally modulated laser (EML) has been simulated. TEDC has been tested in links without chromatic dispersion, with enough bandwidth, and without equalization. Only the receiver (Rx) input power TEDs have been varied. It could be verified that the TED curve was not significantly affected by a power reduction of 10dBm. The curve is symmetric and without a hang-up region (only at 180°phase).

Fig. 6 shows a functional block diagram of a receiver with digital filter and clock and data recovery (CDR) used in connection with an embodiment of the present invention. The optical transmission system with EML shown in Fig. 1 can be experimentally verified. The received signal is equalized by a 4-tap finite impulse response (FIR) with delay elements (T) and filter coefficients $C_{-1}$, $C_0$, $C_1$ and $C_2$ before a CDR block to obtain a PAM-4 signal. The suggested phase detector according to the embodiment and a conventional linear phase detector are used in CR loop with a bandwidth of 1MHz.

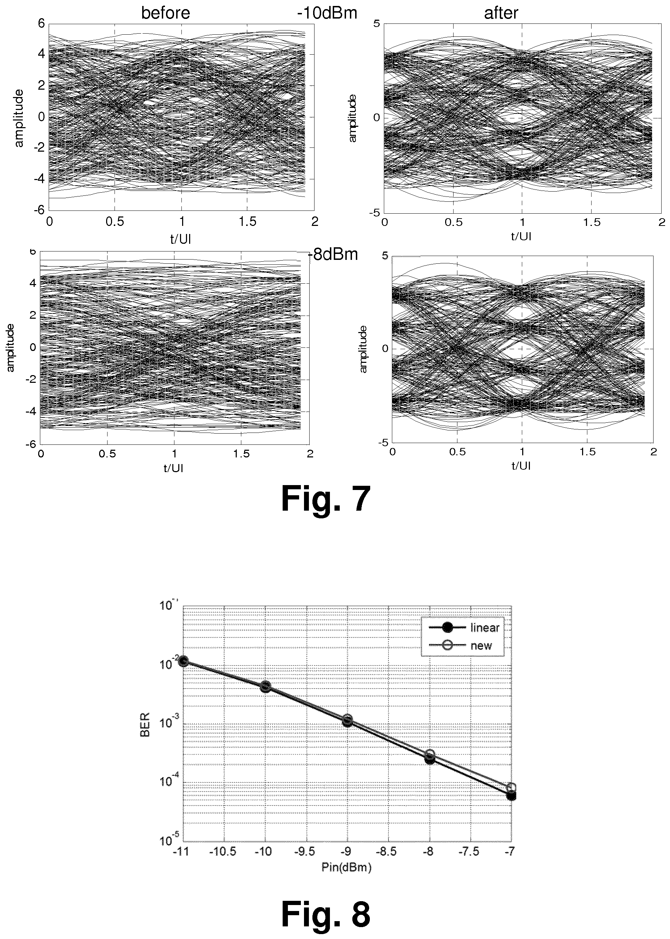

Fig. 7 shows normalized time diagrams with eye diagrams before and after the equalization shown on Fig. 6 with input power Pin of -8 and -10dBm. It can be seen that after equalization eye diagrams can be identified, so that clock and data recovery is facilitated.

Fig. 8 shows bit error rates over input power for a conventional linear phase detector and a phase detector according the embodiment. Due to the desired single sample per symbol approach and pure digital operations, the BER is reduced by no more than 0.15dBm compared to the conventional linear phase detection which is supposed to be the best in the class. However, the proposed architecture according to the embodiment is more appropriate at high Baud rates where oversampling and analog signal processing is very difficult to implement.

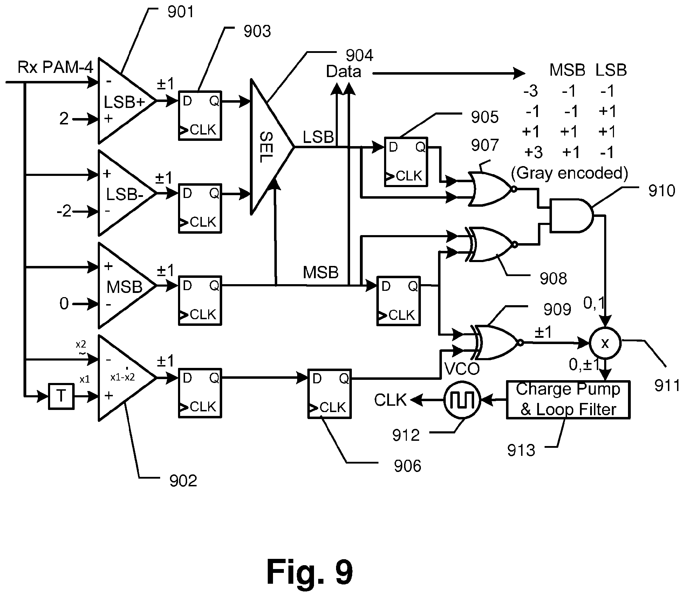

Fig. 9 shows a schematic block diagram of a clock and data recovery device using a phase detector according the embodiment.

The proposed phase detector according to the embodiment uses the known PAM-4 2-bit ADC (four left-most comparators in Fig. 9) that first outputs the most significant bit (MSB) and two of the least significant bits (LSB- and LSB+). The MSB output and the outputs of the other comparators are temporarily stored in respective subsequent D-flip-flops 903, and the MSB output is supplied to a selector (SEL) 904 to select the correct LSB and output two PAM-4 bits DATA (MSB, LSB) according to the small truth table indicated above D-flip-flop 905. It is noted that the first comparator 901 is connected in an inverting mode so that its output is inverted to generate a Gray encoded signal. A further comparator 902 is added to obtain the difference between two samples (x1 and x2) at a distance of one symbol period (the delay line T can be a simple sample-and-hold block).

Furthermore, some D flip flops 903, 905 and 906 and logical blocks 907-910 are added to generate the phase detector output according to the truth table of Fig. 5 so as to generate a driving signal for a voltage-controlled oscillator (VCO) 912 via a low pass filter (LPF) 913.

More specifically, NAND gate 907, XNOR gate 908 and AND gate 910 serve to provide a control signal for a gate device 911 which provides the digital output ("+1" or "-1") of the XNOR gate 909 as phase detector output if the output of the AND gate 910 is on an active state (i.e., "1"), or which provides a logical output "0" if the output of the AND gate 910 is on an inactive state (i.e., "0"). Thus, the logical output "0" of the AND gate 910 reflects the last row "otherwise" in the truth table of Fig. 5, i.e., x1 and x2 do not have the same sign. The XNOR gate 909 with its two input signals MSB and (x1-x2) reflects the remaining upper four rows of the truth table in Fig. 5, where x1 and x2 have the same sign.

Thus, all blocks after the four input comparators are digital. The phase detector output *out* can be described by the following equation (1) that helps to better understand the phase detector functionality:

$$out = (sign(x1) + sign(x2)) * sign(x1-x2) \text{ if } abs(x1) > 2 \text{ and } abs(x2) > 2 \qquad (1)$$

Thus, if the absolute values of the samples x1 and x2 are both larger than the amplitude level "2", the phase detector output is given by the sum of sign values of the samples x1 and x2, multiplied by the sign value of the difference between the samples x1 and x2.

In another embodiment, the following two additional options or modes could be added:

$$If\ x1 > 2\ and\ x2 > 2,\ then\ out = sign(x1-x2) \qquad (2)$$

$$If\ x1 < 2\ and\ x2 < 2,\ then\ out = sign\ (x2-x1) \qquad (3)$$

Thus, if the amplitudes of the samples x1 and x2 are both above level "2", the phase detector output is given by the sign of the difference x1-x2. On the other hand, if the amplitude of the samples x1 and x2 are both below level "2", the phase detector output is given by the sign of the difference x2-x1. That is, depending on the amplitude range, the output of the phase detector is inverted.

It is however noted that the present invention is not limited to PAM-4 signals with four levels -3, -1, 1 and 3. (i.e., M=4). It can be used in any multi-level transmission system with M levels in general. For example, it could be implemented in a PAM-8 transmission system with M=8 levels -7,-5,-3, -1, 1, 3, 5, and 7, where the phase detector will not consider amplitudes between the levels -6 and 6. Only outer eyes and amplitudes smaller than -6 and greater than 6 are considered. The block diagram of Fig. 9 is valid for M=4, but for M=8 this schematic would then have to be modified. In this case, we seven comparators would be required at the input to quantize the received signal.

As already mentioned above, one comparator output in Fig. 9 can be inverted due to Gray mapping of the PAM-4 signal and this is efficiently used for Gray decoding and the phase detector logic (to detect signals below the levels -2 and above the level 2). In case of PAM-8 transmission system, more comparators outputs must be inverted when Gray decoding is performed. So, the schematic will work for PAM-8 transmission systems with Gray codes "000", "001", "011", "010", "110", 111", "101", and "100", but more comparators should be added. At least the output of the comparator for the highest level may be inverted and the same may be done with comparators of levels 3 and 5.

In summary, the present invention relates to an apparatus and method for recovering clock and data from an M-level signal of a receiver in a transmission system, wherein a first analog data (x2) of the M-level signal is converted to a digital data, an amplitude difference between the first analog data (x2) and a second analog data (x1) is compared, and a digital output signal is provided through a truth table based on the digital data and the result of comparison of the amplitude difference, wherein the first analog data (x2) and the second analog data (x1) are sampled at a distance of one symbol period with respect to each of the first analog data (x2) and the second analog data (x1), and the first analog data (x2) and the second analog data (x1) have an identical polarity.

While the invention has been illustrated and described in detail in the drawings and the foregoing description, such illustration and description are to be considered illustrative or exemplary and not restrictive. The invention is not limited to the disclosed embodiments. From reading the present disclosure, other modifications will be apparent to a person skilled in the art. Such modifications may involve other features which are already known in the art and which may be used instead of or in addition to features already described herein. In particular, the present invention can be applied to any multilevel transmission system. More specifically, the transmission system is not restricted to an optical transmission system. Rather, the present invention can be applied to any wired or wireless coherent or non-coherent transmission system. The transmitter and receiver device of the proposed system can be implemented in discrete hardware or based on software routines for controlling signal processors at the transmission and reception side.

The invention has been described in conjunction with various embodiments herein. However, other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage.

Although the present invention has been described with reference to specific features and embodiments thereof, it is evident that various modifications and combinations can be made thereto without departing from the scope of the invention. The specification and drawings are, accordingly, to be regarded simply as an illustration of the invention as defined by the appended claims, and are contemplated to cover any and all modifications, variations, combinations or equivalents that fall within the scope of the present invention.

**Claims**

1. An apparatus for recovering clock and data from an M-level signal of a receiver in a transmission system, the apparatus having an input, a data output and a clock output and comprising:

   - an M-level $\log_2(M)$-bit analog-to-digital converter connected at the input of the apparatus, the M-level $\log_2(M)$-bit analog-to-digital converter being adapted to convert a first analog data (x1) of the M-level signal to a digital data received at the data output;
   - a first comparator (902) connected at the input of the apparatus, the first comparator (902) being adapted to compare an amplitude difference between the first analog data (x1) and a second analog data (x2); and
   - a logic unit (905-911) connected at the clock output of the apparatus, the logic unit (905-911) being adapted to provide through a truth table a digital output signal based on the digital data and the result of comparison of the amplitude difference,

   wherein:

   - the first analog data (x1) and the second analog data (x2) are sampled at a distance of one symbol period with respect to each of the first analog data (x1) and the second analog data (x2);
   - the first analog data (x1) and the second analog data (x2) have an identical sign, and
   - the M-level $\log_2(M)$-bit analog-to-digital converter comprises M-1 comparators (901) and M-1 D-type flip-flops (903), each one of the M-1 D-type flip-flops (903) being connected to a respective output of each one of the M-1 comparators (901) and each one of the M-1 comparators (901) being connected to a respective reference amplitude threshold and the input, wherein at least the output of the M-1 comparator (901) with the highest reference amplitude threshold is inverted.

2. The apparatus of claim 1, wherein the M-1 comparators (901) and the first comparator (902) provide an output of logic value being either -1 or +1.

3. The apparatus of claim 1, wherein the digital output signal is given through the truth table by the following equation:

$$(sign(x1)+sign(x2))*sign(x1-x2)$$

   where |x1| > M-2, x21 > M-2, sign(x1) and sign(x2) correspond to the sign of the logic value output by a second comparator amongst the M-1 comparators, the second comparator outputting the most significant bit (MSB), and sign(x1-x2) corresponds to the sign of the logic value output by the first comparator (902).

4. The apparatus of any one of the preceding claims, wherein the M-level signal is a M-pulse amplitude modulation signal.

5. The apparatus of any one of the preceding claims, wherein the first analog data (x1) and the second analog data (x2) have an amplitude outside the range from 2-M to M-2.

6. The apparatus of claim 1, wherein M equals 4 and wherein the M-1 comparators (901) have respective reference amplitude thresholds equal to -2, 0 and +2 and the M-level analog signal has amplitude levels equal to -3, -1, +1 and +3.

7. The apparatus of claim 1, wherein M equals 8 and wherein the M-1 comparators (901) have respective reference amplitude thresholds equal to -6, 0 and +6 and the M-level analog signal has amplitude levels equal to -7, -5, -3, -1, +1, +3, +5 and +7.

8. The apparatus of any one of the preceding claims, wherein the apparatus further comprises:

   - a filter (913) adapted to filter the digital output signal; and

- an oscillator (912) adapted to receive the filtered digital output signal and generate a clock signal based on the received filtered digital output signal.

9. A method for recovering clock and data from an M-level signal of a receiver in a transmission system, the method comprising the following steps:

- converting a first analog data (x1) of the M-level signal to a digital data;
- comparing an amplitude difference between the first analog data (x1) and a second analog data (x2); and
- providing through a truth table a digital output signal based on the digital data and the result of comparison of the amplitude difference,

wherein:

- the first analog data (x1) and the second analog data (x2) are sampled at a distance of one symbol period with respect to each of the first analog data (x1) and the second analog data (x2); and
- the first analog data (x1) and the second analog data (x2) have an identical sign, and
- the first analog data (x1) and the second analog data (x2) that are in the range from amplitude level "-(M-2)" to amplitude level "M-2" are discarded.

10. The method of claim 9, wherein the method further comprises the following steps:

- filtering the digital output signal;
- receiving the filtered digital output signal; and
- generating a clock signal based on the received filtered digital output signal.


**Patentansprüche**

1. Vorrichtung zur Rückgewinnung von Takt und Daten aus einem M-Pegel-Signal eines Empfängers in einem Übertragungssystem, wobei die Vorrichtung einen Eingang, einen Datenausgang und einen Taktausgang aufweist und Folgendes umfasst:

- einen M-Pegel-$\log_2$(M)-Bit-A/D-Wandler, der mit dem Eingang der Vorrichtung verbunden ist, wobei der M-Pegel-$\log_2$(M)-Bit-A/D-Wandler dazu angepasst ist, erste analoge Daten (x1) des M-Pegel-Signals in digitale Daten umzuwandeln, die an dem Datenausgang empfangen werden;
- einen ersten Komparator (902), der mit dem Eingang der Vorrichtung verbunden ist, wobei der erste Komparator (902) dazu angepasst ist, eine Amplitudendifferenz zwischen den ersten analogen Daten (x1) und zweiten analogen Daten (x2) zu vergleichen; und
- eine Logikeinheit (905-911), die mit dem Taktausgang der Vorrichtung verbunden ist, wobei die Logikeinheit (905-911) dazu angepasst ist, mittels einer Wahrheitstabelle ein digitales Ausgangssignal bereitzustellen, das auf den digitalen Daten und dem Ergebnis des Vergleichs der Amplitudendifferenz basiert,

wobei:

- die ersten analogen Daten (x1) und die zweiten analogen Daten (x2) in einem Abstand einer ersten Symbolperiode in Bezug auf sowohl die ersten analogen Daten (x1) als auch die zweiten analogen Daten (x2) abgetastet werden;
- die ersten analogen Daten (x1) und die zweiten analogen Daten (x2) ein identisches Vorzeichen aufweisen, und
- der M-Pegel-$\log_2$(M)-Bit-A/D-Wandler M-1-Komparatoren (901) und M-1-D-Typ-Flipflops (903) umfasst, wobei jeder der M-1-D-Typ-Flipflops (903) mit einem entsprechenden Ausgang jedes der M-1-Komparatoren (901) verbunden ist und jeder der M-1-Komparatoren (901) mit einem entsprechenden Referenzamplitudenschwellenwert und dem Eingang verbunden ist, wobei zumindest der Ausgang des M-1-Komparators (901) mit der höchsten Referenzamplitude invertiert ist.

2. Vorrichtung nach Anspruch 1, wobei die M-1-Komparatoren (901) und der erste Komparator (902) eine Ausgabe eines Logikwerts bereitstellen, die entweder -1 oder +1 beträgt.

3. Vorrichtung nach Anspruch 1, wobei das digitale Ausgangssignal mittels der Wahrheitstabelle durch die folgende

Gleichung gegeben ist:

$$(Vorzeichen(x1)+Vorzeichen(x2))*Vorzeichen(x1-x2)$$

wobei $|x1| > M-2$, $|x2| > M-2$, Vorzeichen (x1) und Vorzeichen(x2) dem Vorzeichen der Logikwertausgabe durch einen zweiten Komparator und den M-1-Komparatoren entsprechen, wobei der zweite Komparator das hochwertigste Bit (MSB) ausgibt und Vorzeichen(x1-x2) dem Vorzeichen der Logikwertausgabe durch den ersten Komparator (902) entspricht.

4. Vorrichtung nach einem der vorstehenden Ansprüche, wobei das M-Pegel-Signal ein M-Puls-Amplitudenmodulationssignal ist.

5. Vorrichtung nach einem der vorstehenden Ansprüche, wobei die ersten analogen Daten (x1) und die zweiten analogen Daten (x2) eine Amplitude aufweisen, die außerhalb des Bereichs von 2-M bis M-2 liegt.

6. Vorrichtung nach Anspruch 1, wobei M gleich 4 ist und wobei die M-1-Komparatoren (901) entsprechende Referenzamplitudenschwellenwerte aufweisen, die gleich -2, 0 und +2 sind und wobei das analoge M-Pegel-Signal Amplitudenpegel aufweist, die gleich -3, -1, +1 und +3 sind.

7. Vorrichtung nach Anspruch 1, wobei M gleich 8 ist und wobei die M-1-Komparatoren (901) entsprechende Referenzamplitudenschwellenwerte aufweisen, die gleich -6, 0 und +6 sind und wobei das analoge M-Pegel-Signal Amplitudenpegel aufweist, die gleich -7, -5, -3, -1, +1, +3, +5 und +7 sind.

8. Vorrichtung nach einem der vorstehenden Ansprüche, wobei die Vorrichtung ferner Folgendes umfasst:

   - einen Filter (913), der dazu angepasst ist, das digitale Ausgangssignal zu filtern; und
   - einen Oszillator (912), der dazu angepasst ist, das gefilterte digitale Ausgangssignal zu empfangen und auf Grundlage des empfangenen gefilterten digitalen Signals ein Taktsignal zu generieren.

9. Verfahren zur Rückgewinnung von Takt und Daten aus einem M-Pegel-Signal eines Empfängers in einem Übertragungssystem, wobei das Verfahren die folgenden Schritte umfasst:

   - Umwandeln von ersten analogen Daten (x1) des M-Pegel-Signals in digitale Daten;
   - Vergleichen einer Amplitudendifferenz zwischen den ersten analogen Daten (x1) und zweiten analogen Daten (x2); und
   - Bereitstellen eines digitalen Ausgangssignals auf Grundlage der digitalen Daten und des Ergebnisses des Vergleichs der Amplitudendifferenz mittels einer Wahrheitstabelle,

   wobei:

   - die ersten analogen Daten (x1) und die zweiten analogen Daten (x2) in einem Abstand einer ersten Symbolperiode in Bezug auf sowohl die ersten analogen Daten (x1) als auch die zweiten analogen Daten (x2) abgetastet werden; und
   - die ersten analogen Daten (x1) und die zweiten analogen Daten (x2) ein identisches Vorzeichen aufweisen, und
   - die ersten analogen Daten (x1) und die zweiten analogen Daten (x2), die in dem Bereich von dem Amplitudenpegel "-(M-2)" bis zu dem Amplitudenpegel "M-2" liegen, verworfen werden.

10. Verfahren nach Anspruch 9, wobei das Verfahren ferner die folgenden Schritte umfasst:

   - Filtern des digitalen Ausgangssignals;
   - Empfangen des gefilterten digitalen Ausgangssignals; und
   - Generieren eines Taktsignals auf Grundlage des empfangenen gefilterten digitalen Ausgangssignals.

**Revendications**

1. Appareil de récupération d'horloge et de données à partir d'un signal de niveau M d'un récepteur dans un système de transmission, l'appareil ayant une entrée, une sortie de données et une sortie d'horloge et comprenant :

- un convertisseur analogique-numérique de bit de $\log_2(M)$ de niveau M connecté au niveau de l'entrée de l'appareil, le convertisseur analogique-numérique de bit de $\log_2(M)$ de niveau M étant adapté pour convertir une première donnée analogique (x1) du signal de niveau M en une donnée numérique reçue au niveau de la sortie de données ;
- un premier comparateur (902) connecté au niveau de l'entrée de l'appareil, le premier comparateur (902) étant adapté pour comparer une différence d'amplitude entre la première donnée analogique (x1) et une seconde donnée analogique (x2) ; et
- une unité logique (905 à 911) connectée au niveau de la sortie d'horloge de l'appareil, l'unité logique (905 à 911) étant adaptée pour fournir par le biais d'une table de vérité un signal de sortie numérique d'après la donnée numérique et le résultat de comparaison de la différence d'amplitude,

dans lequel :

- la première donnée analogique (x1) et la seconde donnée analogique (x2) sont échantillonnées à une distance d'une période de symbole par rapport à chacune de la première donnée analogique (x1) et de la seconde donnée analogique (x2) ;
- la première donnée analogique (x1) et la seconde donnée analogique (x2) ont un signe identique, et
- le convertisseur analogique-numérique de bit de $\log_2(M)$ de niveau M comprend M-1 comparateurs (901) et M-1 bascules de type D (903), chacune des M-1 bascules de type D (903) étant connectée à une sortie respective de chacun des M-1 comparateurs (901) et chacun des M-1 comparateurs (901) étant connecté à un seuil d'amplitude de référence respectif et à l'entrée, dans lequel au moins la sortie du M-1 comparateur (901) avec le seuil d'amplitude de référence le plus élevé est inversée.

2. Appareil selon la revendication 1, dans lequel les M-1 comparateurs (901) et le premier comparateur (902) fournissent une valeur logique délivrée en sortie qui est soit -1 soit +1.

3. Appareil selon la revendication 1, dans lequel le signal de sortie numérique est donné par le biais de la table de vérité par l'équation suivante :

$$(\text{signe } (x1) + \text{signe } (x2)) * \text{signe}(x1-x2)$$

où |x1| > M-2, |x2| > M-2, signe(x1) et signe(x2) correspondent au signe de la valeur logique délivrée en sortie par un second comparateur parmi les M-1 comparateurs, le second comparateur délivrant en sortie le bit le plus significatif (MSB), et le signe(x1-x2) correspond au signe de la valeur logique délivrée en sortie par le premier comparateur (902).

4. Appareil selon l'une quelconque des revendications précédentes, dans lequel le signal de niveau M est un signal de modulation d'impulsions M en amplitude.

5. Appareil selon l'une quelconque des revendications précédentes, dans lequel la première donnée analogique (x1) et la seconde donnée analogique (x2) ont une amplitude en dehors de la plage de 2-M à M-2.

6. Appareil selon la revendication 1, dans lequel M est égal à 4 et dans lequel les M-1 comparateurs (901) ont des seuils d'amplitude de référence respectifs égaux à -2, 0 et +2 et le signal analogique de niveau M a des niveaux d'amplitude égaux à -3, -1, +1 et +3.

7. Appareil selon la revendication 1, dans lequel M est égal à 8 et dans lequel les M-1 comparateurs (901) ont des seuils d'amplitude de référence respectifs égaux à -6, 0 et +6 et le signal analogique de niveau M a des niveaux d'amplitude égaux à -7, -5, -3, -1, +1, +3, +5 et +7.

8. Appareil selon l'une quelconque des revendications précédentes, l'appareil comprenant en outre :

- un filtre (913) adapté pour filtrer le signal de sortie numérique ; et
- un oscillateur (912) adapté pour recevoir le signal de sortie numérique filtré et générer un signal d'horloge d'après le signal de sortie numérique filtré reçu.

**9.** Procédé de récupération d'horloge et de données à partir d'un signal de niveau M d'un récepteur dans un système de transmission, le procédé comprenant les étapes suivantes :

- la conversion d'une première donnée analogique (x1) du signal de niveau M en une donnée numérique ;
- la comparaison d'une différence d'amplitude entre la première donnée analogique (x1) et une seconde donnée analogique (x2) ; et
- la fourniture par le biais d'une table de vérité d'un signal de sortie numérique d'après la donnée numérique et le résultat de comparaison de la différence d'amplitude,

dans lequel :

- la première donnée analogique (x1) et la seconde donnée analogique (x2) sont échantillonnées à une distance d'une période de symbole par rapport à chacune de la première donnée analogique (x1) et de la seconde donnée analogique (x2) ; et
- la première donnée analogique (x1) et la seconde donnée analogique (x2) ont un signe identique, et
- la première donnée analogique (x1) et la seconde donnée analogique (x2) qui sont dans la plage d'un niveau d'amplitude « -(M-2) » à un niveau d'amplitude « M-2 » sont rejetées.

**10.** Procédé selon la revendication 9, le procédé comprenant en outre les étapes suivantes :

- le filtrage du signal de sortie numérique ;
- la réception du signal de sortie numérique filtré ; et
- la génération d'un signal d'horloge d'après le signal de sortie numérique filtré reçu.

prior art

# Fig. 1

# Fig. 2

| Sign(A) | Sign(C) | Sign(B) | Out |
|---------|---------|---------|-----|
| - | -/+ | - | 0 |
| - | - | + | -1 |
| + | + | - | -1 |
| - | + | + | +1 |
| + | - | - | +1 |
| + | -/+ | + | 0 |

# Fig. 3

# Fig. 4

| abs(x1)>2, abs(x2)>2, MSB(x1)=MSB(x2) | | | |
|---|---|---|---|
| sign(x1) | sign(x2) | sign(x1-x2) | out |
| - | - | - | + |
| - | - | + | - |
| + | + | - | - |
| + | + | + | + |
| otherwise | | | 0 |

# Fig. 5

# Fig. 6

Fig. 7

Fig. 8

**Fig. 9**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2945335 A1

### Non-patent literature cited in the description

- **J. D. H. ALEXANDER.** *Electron. Lett.,* 1975, vol. 11, 541-542
- **R. FARJAD-RAD et al.** *IEEE Journal of Solid State Circuits,* 2000, vol. 35, 757-764
- **J.L. ZERBE et al.** *IEEE Journal of Solid State Circuits,* 2003, vol. 38, 2121-2130
- **FAISAL . MUSA et al.** *Clock recovery in high-speed multilevel serial links,* 2013